# EUROPEAN PATENT APPLICATION

(11) **EP 4 633 030 A1**
(43) Date of publication of application: **15.10.2025**
(21) Application number: 23909798.3
(22) Date of filing: 22.11.2023
(51) Int. Cl.: H02M 5/44, H05K 7/20, H05K 9/00

(54) **POWER CONVERTER**

(30) Priority: 29.12.2022 CN 202211711200; 05.09.2023 CN 202311139670
(71) Applicant: HUAWEI DIGITAL POWER TECHNOLOGIES CO., LTD., Shenzhen Guangdong 518043 (CN)
(72) Inventor: SHI, Hui, Shenzhen, Guangdong 518043 (CN); HUI, Libin, Shenzhen, Guangdong 518043 (CN); HU, Tianqi, Shenzhen, Guangdong 518043 (CN); RU, Yi, Shenzhen, Guangdong 518043 (CN); MA, Zheng, Shenzhen, Guangdong 518043 (CN)
(74) Representative: Isarpatent
(86) International application number: PCT/CN2023/133277
(87) International publication number: WO 2024/139866

(57) **Abstract**

This application provides a power converter. The power converter includes a housing and a power conversion circuit. A plurality of accommodation cavities separated from each other are disposed in the housing, and the plurality of accommodation cavities separated from each other include a first accommodation cavity, a second accommodation cavity, and a third accommodation cavity. The power conversion circuit includes a first electromagnetic compatibility module, a bus capacitor, and a second electromagnetic compatibility module. The first accommodation cavity is configured to accommodate the first electromagnetic compatibility module, the second accommodation cavity is configured to accommodate the bus capacitor, and the third accommodation cavity is configured to accommodate the second electromagnetic compatibility module. The first accommodation cavity and the third accommodation cavity are located on two sides of the second accommodation cavity. This application is implemented, so that EMC of the power converter can be improved.

## Description

This application claims priorities to Chinese Patent Application No. 202211711200.9, filed with the China National Intellectual Property Administration on December 29, 2022 and entitled "POWER CONVERTER", and to Chinese Patent Application No. 202311139670.7, filed with the China National Intellectual Property Administration on September 5, 2023 and entitled "POWER CONVERTER", both of which are incorporated herein by reference in their entireties.

### TECHNICAL FIELD

This application relates to the field of power supply technologies, and in particular, to a power converter.

### BACKGROUND

A power converter can convert a current into another type of current, and is widely used in a power supply system. The power converter can be put into commercial use only when the power converter meets an electromagnetic compatibility (Electro Magnetic Compatibility, EMC) standard. As a switching frequency of the power converter increases and an output power of the power converter increases, electromagnetic susceptibility (Electromagnetic Susceptibility, EMS) of the power converter to another electronic device decreases. An electromagnetic signal generated by the power converter also causes severe electromagnetic interference to another electronic device, that is, the electromagnetic interference (Electro Magnetic Interference, EMI) of the power converter increases. In general, as the switching frequency of the power converter increases and the output power of the power converter increases, a higher requirement for EMC is imposed on the power converter. Therefore, how to improve the EMC of the power converter is a key research problem.

### SUMMARY

This application provides a power converter, to improve EMC of the power converter.

According to a first aspect, an embodiment of this application provides a power converter. The power converter includes a housing and a power conversion circuit. A plurality of accommodation cavities separated from each other are disposed in the housing, and the plurality of accommodation cavities separated from each other include a first accommodation cavity, a second accommodation cavity, and a third accommodation cavity.

The power conversion circuit includes a first electromagnetic compatibility module, a bus capacitor, and a second electromagnetic compatibility module. The first accommodation cavity is configured to accommodate the first electromagnetic compatibility module, the second accommodation cavity is configured to accommodate the bus capacitor, and the third accommodation cavity is configured to accommodate the second electromagnetic compatibility module. The first accommodation cavity and the third accommodation cavity are located on two sides of the second accommodation cavity.

In this embodiment of this application, currents flow in one direction, so that crosstalk between the currents can be reduced. This improves effect of EMC of the power converter.

With reference to the first aspect, in a first possible implementation, the first accommodation cavity and the third accommodation cavity are symmetrically distributed with respect to the second accommodation cavity. Implementation of this embodiment of this application helps further improve effect of the EMC of the power converter, and further improve power density of the power converter.

With reference to the first aspect or the first possible implementation of the first aspect, in a second possible implementation, the plurality of accommodation cavities separated from each other further include a fourth accommodation cavity, and the power conversion circuit further includes a first power inductor module. The fourth accommodation cavity is configured to accommodate the first power inductor module. The fourth accommodation cavity and the first accommodation cavity are located on a same side of the second accommodation cavity.

In this embodiment of this application, the first power inductor module is added to the power converter, so that interference from an input side of the power converter may be filtered out. In addition, the first power inductor module is disposed on a same side of the first accommodation cavity accommodating the first electromagnetic compatibility module, and the currents still flow in one direction, for example, in a clockwise direction, so that effect of the EMC of the power converter may be further improved.

With reference to the second possible implementation of the first aspect, in a third possible implementation, the power converter further includes a printed circuit board located in the housing. The printed circuit board is configured to carry the first electromagnetic compatibility module and the bus capacitor. A side that is of the first power inductor module and that faces the printed circuit board is provided with a shielding board. The first power inductor module establishes, by using a screw, an electrical connection to the first electromagnetic compatibility module and the bus capacitor that are on the printed circuit board.

With reference to the first aspect or any one of the foregoing possible implementations of the first aspect, in a fourth possible implementation, the plurality of accommodation cavities separated from each other further include a fifth accommodation cavity, and the power conversion circuit further includes a second power inductor module. The fifth accommodation cavity is configured to accommodate the second power inductor module. The fifth accommodation cavity and the third accommodation cavity are located on a same side of the second accommodation cavity.

In this embodiment of this application, the second power inductor module is added to the power converter, so that interference from an output side of the power converter may be filtered out. In addition, the second power inductor module is disposed on a same side of the third accommodation cavity accommodating the second electromagnetic compatibility module, and the currents still flow in one direction, for example, in a clockwise direction, so that effect of the EMC of the power converter may be further improved.

With reference to the fourth possible implementation of the first aspect, in a fifth possible implementation, the power converter further includes the printed circuit board located in the housing. The printed circuit board is configured to carry the bus capacitor and the second electromagnetic compatibility module. A side that is of the second power inductor module and that faces the printed circuit board is provided with a shielding board. The second power inductor module establishes, by using a screw, an electrical connection to the bus capacitor and the second electromagnetic compatibility module that are on the printed circuit board.

With reference to the first aspect or any one of the foregoing possible implementations of the first aspect, in a sixth possible implementation, the housing includes a bottom plate, a housing sidewall, and a cover plate. The bottom plate, the housing sidewall, and the cover plate define the plurality of accommodation cavities separated from each other.

With reference to the sixth possible implementation of the first aspect, in a seventh possible implementation, a surface that is of the housing sidewall and that faces the cover plate is provided with a first conductive connecting piece. A surface that is of the cover plate and that faces the housing sidewall is correspondingly provided with a second conductive connecting piece. The first conductive connecting piece is attached to the second conductive connecting piece.

This embodiment of this application is implemented. In a case in which the first conductive connecting piece is attached to the second conductive connecting piece, the housing sidewall and the cover plate may form a closed conductive cavity, to avoid an external leakage of electromagnetic interference generated by the power converter. This further improves effect of the EMC of the power converter.

With reference to the first aspect or any one of the foregoing possible implementations of the first aspect, in an eighth possible implementation, the power converter further includes the printed circuit board located in the housing. The printed circuit board is configured to carry the first electromagnetic compatibility module, the bus capacitor, and the second electromagnetic compatibility module. The first electromagnetic compatibility module, the bus capacitor, and the second electromagnetic compatibility module are located on a surface that is of the printed circuit board and that faces the bottom plate of the housing.

With reference to the eighth possible implementation of the first aspect, in a ninth possible implementation, a surface that is of a cavity sidewall of any one of the plurality of accommodation cavities separated from each other and that faces the printed circuit board is provided with a third conductive connecting piece. A surface that is of the printed circuit board and that faces the cavity sidewall is correspondingly provided with a fourth conductive connecting piece. The third conductive connecting piece is attached to the fourth conductive connecting piece.

This embodiment of this application is implemented. The third conductive connecting piece is attached to the fourth conductive connecting piece. The cavity sidewall of any one of the cavities and the printed circuit board may form a closed or semi-closed conductive cavity, to reduce electromagnetic interference between accommodation cavities and avoid superposition of the electromagnetic interference. This may improve effect of the EMC of the power converter.

With reference to the first aspect or any one of the foregoing possible implementations of the first aspect, in a tenth possible implementation, the first accommodation cavity has an input port. The input port is configured to establish a connection between the first electromagnetic compatibility module and a direct current power supply. The third accommodation cavity has an output terminal. The output terminal is configured to establish a connection between the second electromagnetic compatibility module and an alternating current load.

The power conversion circuit further includes a first DC/AC module. The first DC/AC module is configured to: convert a first direct current output by the first electromagnetic compatibility module into a first alternating current, and transmit the first alternating current to the second electromagnetic compatibility module.

With reference to the tenth possible implementation of the first aspect, in an eleventh possible implementation, the first electromagnetic compatibility module includes at least one first inductor and at least one first capacitor. The first inductor and the first capacitor are configured to form a first low-pass filter circuit. The first low-pass filter circuit may filter out high-frequency interference caused by the direct current power supply. The second electromagnetic compatibility module includes at least one second inductor and at least one second capacitor. The second inductor and the second capacitor are configured to form a second low-pass filter circuit. The second low-pass filter circuit may filter out high-frequency interference generated by the power converter.

With reference to the tenth possible implementation of the first aspect or the eleventh possible implementation of the first aspect, in a twelfth possible implementation, the first DC/AC module includes a first switch unit and a second switch unit. The plurality of accommodation cavities separated from each other include a sixth accommodation cavity and a seventh accommodation cavity. The sixth accommodation cavity is configured to accommodate the first switch unit. The seventh accommodation cavity is configured to accommodate the second switch unit. The sixth accommodation cavity and the seventh accommodation cavity are located on the two sides of the second accommodation cavity.

This embodiment of this application is implemented. In this embodiment of this application, the first DC/AC module in the power conversion circuit is divided into two parts, and the two parts are respectively disposed on the two sides of the second accommodation cavity, to avoid a squeeze between switching transistors in the first DC/AC module. This facilitates heat dissipation of the first DC/AC module, and may improve security and reliability of the power converter.

With reference to the twelfth possible implementation of the first aspect, in a thirteenth possible implementation, the power converter further includes a first heat sink and a second heat sink. The first heat sink is located in the sixth accommodation cavity and is configured to dissipate heat for the first switch unit. The second heat sink is located in the seventh accommodation cavity and is configured to dissipate heat for the second switch unit.

With reference to the twelfth possible implementation of the first aspect, in a fourteenth possible implementation, the power converter further includes the printed circuit board located in the housing. The printed circuit board is configured to carry the first switch unit and the second switch unit. The first switch unit and the second switch unit are located on the surface that is of the printed circuit board and that faces the bottom plate of the housing.

With reference to the first aspect or the first possible implementation of the first aspect to the ninth possible implementation of the first aspect, in a fifteenth possible implementation, the first accommodation cavity has an input port. The input port is configured to establish a connection between the first electromagnetic compatibility module and an alternating current power supply. The third accommodation cavity has an output terminal. The output terminal is configured to establish a connection between the second electromagnetic compatibility module and an alternating current load.

The power conversion circuit further includes an AC/DC module and a second DC/AC module. The AC/DC module is configured to: convert a second alternating current output by the first electromagnetic compatibility module into a second direct current, and transmit the second direct current to the second DC/AC module.

The second DC/AC module is configured to: convert the second direct current into a third alternating current, and transmit the third alternating current to the second electromagnetic compatibility module.

With reference to the fifteenth possible implementation of the first aspect, in a sixteenth possible implementation, the first electromagnetic compatibility module includes at least one third inductor and at least one third capacitor. The third inductor and the third capacitor are configured to form a third low-pass filter circuit. The third low-pass filter circuit may filter out high-frequency interference caused by the alternating current power supply.

The second electromagnetic compatibility module includes at least one fourth inductor and at least one fourth capacitor. The fourth inductor and the fourth capacitor are configured to form a fourth low-pass filter circuit. The fourth low-pass filter circuit is configured to filter out high-frequency interference generated by the power converter.

With reference to the fifteenth possible implementation of the first aspect, in a seventeenth possible implementation, the AC/DC module includes a third switch unit, and the second DC/AC module includes a fourth switch unit. The plurality of accommodation cavities separated from each other include a sixth accommodation cavity and a seventh accommodation cavity. The sixth accommodation cavity is configured to accommodate the third switch unit. The seventh accommodation cavity is configured to accommodate the fourth switch unit. The sixth accommodation cavity and the seventh accommodation cavity are located on the two sides of the second accommodation cavity.

With reference to the seventeenth possible implementation of the first aspect, in an eighteenth possible implementation, the power converter further includes a first heat sink and a second heat sink. The first heat sink is located in the sixth accommodation cavity and is configured to dissipate heat for the third switch unit. The second heat sink is located in the seventh accommodation cavity and is configured to dissipate heat for the fourth switch unit.

With reference to the seventeenth possible implementation of the first aspect, in a nineteenth possible implementation, the power converter further includes the printed circuit board located in the housing. The printed circuit board is configured to carry the third switch unit and the fourth switch unit. The third switch unit and the fourth switch unit are located on the surface that is of the printed circuit board and that faces the bottom plate of the housing.

With reference to the eighth possible implementation of the first aspect, in a twentieth possible implementation, the printed circuit board includes an EMC conductive coating. The EMC conductive coating on the printed circuit board is closely attached to a cavity sidewall of any one of the plurality of accommodation cavities separated from each other. In a direction perpendicular to the printed circuit board, a projection of the EMC conductive coating on the printed circuit board overlaps a projection of the cavity sidewall of any one of the plurality of accommodation cavities separated from each other.

An exposed metal conductive portion on the printed circuit board is directly connected to the cavity sidewall, so that the accommodation cavity is enabled to form a closed or semi-closed EMC isolation cavity. The isolation cavity may absorb or reflect an interference signal several times. This generates an energy loss, so that the interference signal arriving in the isolation cavity is greatly weakened, and isolation effect of the EMC is achieved.

With reference to the twentieth possible implementation of the first aspect, in a twenty-first possible implementation, the housing beside the cavity sidewall of any one of the plurality of accommodation cavities separated from each other is provided with a threaded hole. The printed circuit board is provided with a threaded through hole. In a direction perpendicular to the printed circuit board, a projection of the threaded hole overlaps a projection of the threaded through hole. The threaded hole and the threaded through hole are configured to fasten a connection between the cavity sidewall of any one of the plurality of accommodation cavities separated from each other and an EMC conductive coating on the printed circuit board.

The threaded hole close to the housing sidewall is disposed, so that an electrical connection between the housing sidewall and the printed circuit board can be better ensured. Even if the power conversion device vibrates due to device installation, shift, or the like, the housing sidewall and the printed circuit board can still be tightly connected, so that reliability of isolation effect of the EMC is ensured.

### BRIEF DESCRIPTION OF DRAWINGS

FIG. 1 is a schematic diagram of a three-dimensional structure of a power converter according to an embodiment of this application;
FIG. 2 is a block diagram of a circuit of a power converter according to an embodiment of this application;
FIG. 3 is a schematic diagram of another three-dimensional structure of a power converter according to an embodiment of this application;
FIG. 4 to FIG. 6 are schematic diagrams of still another three-dimensional structure of a power converter according to an embodiment of this application;
FIG. 7 is a schematic diagram of yet another three-dimensional structure of a power converter according to an embodiment of this application;
FIG. 8 is a block diagram of another circuit of a power converter according to an embodiment of this application;
FIG. 9 is a schematic diagram of still yet another three-dimensional structure of a power converter according to an embodiment of this application;
FIG. 10 is a block diagram of still another circuit of a power converter according to an embodiment of this application;
FIG. 11 is a block diagram of a structure of a power inductor module according to an embodiment of this application;
FIG. 12 is a block diagram of yet another circuit of a power converter according to an embodiment of this application; and
FIG. 13 is a block diagram of a further three-dimensional structure of a power converter according to an embodiment of this application.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

Implementations of the technical solutions of this application are further described below in detail with reference to the accompanying drawings.

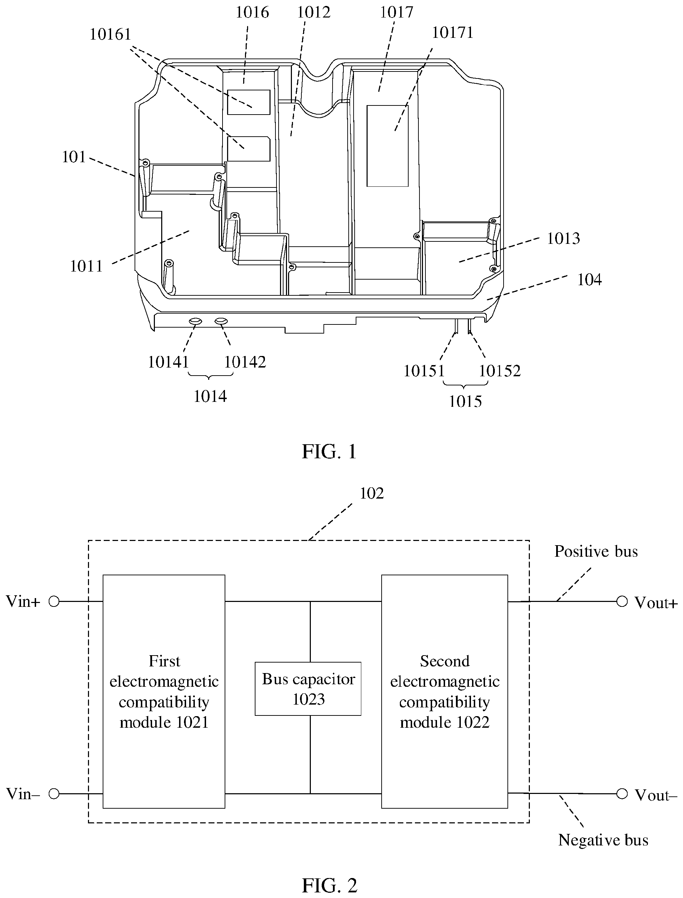

Refer to FIG. 1 and FIG. 2. An embodiment of this application provides a power converter. The power converter includes a housing 101 and a power conversion circuit 102.

A plurality of accommodation cavities separated from each other such as a first accommodation cavity 1011, a second accommodation cavity 1012, and a third accommodation cavity 1013 are disposed in the housing 101. The first accommodation cavity 1011 and the third accommodation cavity 1013 are located on two sides of the second accommodation cavity 1012.

The power conversion circuit 102 includes a first electromagnetic compatibility module 1021, a second electromagnetic compatibility module 1022, and a bus capacitor 1023. In a specific implementation, a connection relationship of the power conversion circuit 102 may be as follows: A positive input end Vin+ and a positive output end Vout+ of the power conversion circuit 102 are connected to a positive bus. A negative input end Vin- and a negative output end Vout- of the power conversion circuit 102 are connected to a negative bus. The bus capacitor 1023 is connected in parallel between the positive bus and the negative bus.

The first electromagnetic compatibility module 1021 is close to the positive input end Vin+ and the negative input end Vin- of the power conversion circuit 102, and may be connected in series to the positive bus, connected in series to the negative bus, or connected in parallel between the positive bus and the negative bus, to suppress electromagnetic interference caused by the positive input end Vin+ and the negative input end Vin-. That is, the first electromagnetic compatibility module 1021 may improve electromagnetic susceptibility (Electromagnetic Susceptibility, EMS) of the power converter. For example, when the first electromagnetic compatibility module 1021 is connected to a direct current power supply, the first electromagnetic compatibility module 1021 includes at least one first inductor and at least one first capacitor. The first inductor and the first capacitor form a first low-pass filter circuit. The first low-pass filter circuit may filter out high-frequency interference caused by the direct current power supply. Alternatively, when the first electromagnetic compatibility module 1021 is connected to an alternating current power supply, the first electromagnetic compatibility module 1021 includes at least one third inductor and at least one third capacitor. The third inductor and the third capacitor form a third low-pass filter circuit. The third low-pass filter circuit may filter out high-frequency interference caused by the alternating current power supply.

The second electromagnetic compatibility module 1022 is close to the positive output end Vout+ and the negative output end Vout- of the power conversion circuit 102, and may be connected in series to the positive bus, connected in series to the negative bus, or connected in parallel between the positive bus and the negative bus, to reduce electromagnetic interference of the power converter to another electronic device. That is, the second electromagnetic compatibility module 1022 may reduce electromagnetic interference (Electro Magnetic Interference, EMI) of the power converter. The second electromagnetic compatibility module 1022 includes at least one second inductor and at least one second capacitor. The second inductor and the second capacitor form a second low-pass filter circuit. The second low-pass filter circuit may filter out high-frequency interference generated by the power converter.

Optionally, in some feasible implementations, specific circuit implementations of the first electromagnetic compatibility module 1021 and the second electromagnetic compatibility module 1022 may be the same or may be different.

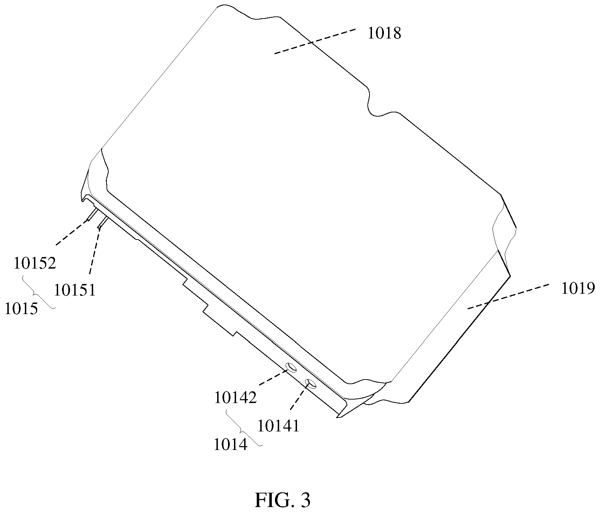

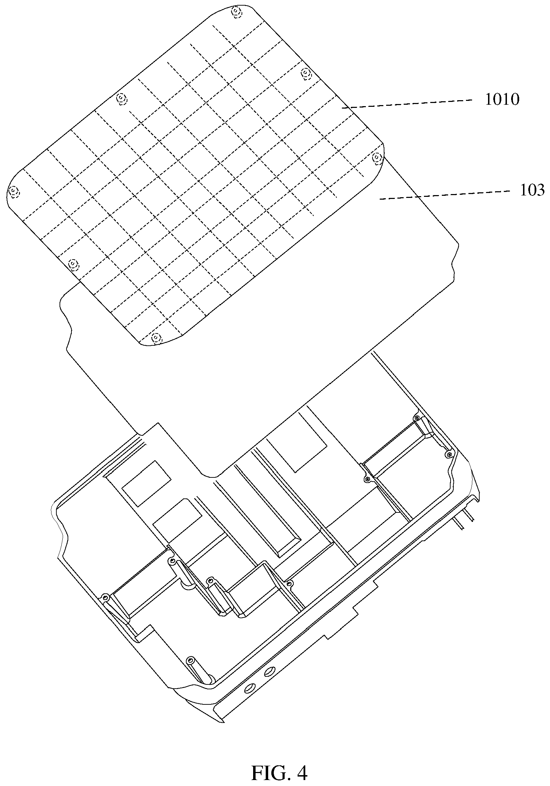

Refer to FIG. 3 and FIG. 4. In a possible implementation, the housing 101 includes a bottom plate 1018, a housing sidewall 1019, and a cover plate 1010. The bottom plate 1018, the housing sidewall 1019, and the cover plate 1010 are enclosed to form the plurality of accommodation cavities separated from each other, for example, the first accommodation cavity 1011, the second accommodation cavity 1012, and the third accommodation cavity 1013. For example, the accommodation cavities may be separated from each other by using an isolation plate, and may be obtained through manufacturing by using an integrated die casting process.

It should be understood that, a die casting material of the housing 101 includes aluminum or an aluminum alloy doped with different elements. The material is a metal conducting material. The power converter further includes a printed circuit board (Printed circuit board, PCB) 103. When there is an electrical connection between the printed circuit board of the power converter and the housing, each accommodation cavity of the power converter, and the PCB may be enabled to form a plurality of fully-closed or semi-closed EMC isolation cavities. When arriving outside the isolation cavity, an interference signal is absorbed, reflected, or reflected several times through the isolation cavity. This generates an energy loss, and the interference signal on an interface inside the isolation cavity is significantly weakened, so that an electrical element located between the plurality of EMC isolation cavities is not affected or is less affected by the interference signal outside the isolation cavity.

The isolation cavity is preferable to be fully enclosed. However, in an actual application scenario, due to various reasons such as PCB cabling and structures, the isolation cavity cannot be completely enclosed, and there may be gaps, lead holes, and the like in the isolation cavity. Such incomplete shielding affects shielding effect to some extent, but only needs to meet product application requirements finally. In addition, the material also has great heat conduction performance. When the power converter operates, heat generated by the device during operating may be quickly conducted to a heat sink connected to the power converter, so that the power converter is ensured to be in a proper operating temperature constantly.

The printed circuit board 103 is provided with the first electromagnetic compatibility module 1021, the second electromagnetic compatibility module 1022, and the bus capacitor 1023. In a specific implementation, the printed circuit board 103 is located in the housing 101. The first electromagnetic compatibility module 1021, the second electromagnetic compatibility module 1022, and the bus capacitor 1023 are disposed on a surface that is of the printed circuit board 103 and that faces the bottom plate 1018. When the printed circuit board 103 covers the housing 101, the first electromagnetic compatibility module 1021 may be disposed in the first accommodation cavity 1011, the second electromagnetic compatibility module 1022 may be disposed in the third accommodation cavity 1013, and the bus capacitor 1023 may be disposed in the second accommodation cavity 1012.

In some feasible implementations, a depth of the first accommodation cavity 1011 may be set based on a height of a device in the first electromagnetic compatibility module 1021. Similarly, a depth of the second accommodation cavity 1012 may be set based on a height of the bus capacitor 1023. A depth of the third accommodation cavity 1013 may be set based on a height of a device in the second electromagnetic compatibility module 1022. In other words, the depth of the first accommodation cavity 1011, the depth of the second accommodation cavity 1012, and the depth of the third accommodation cavity 1013 may be different.

Refer to FIG. 1 and FIG. 2 again. The first accommodation cavity 1011 has an input port 1014. The input port 1014 includes a first input port 10141 and a second input port 10142. When the first input port 10141 is connected to the positive input end Vin+ of the power conversion circuit 102, and the first input port 10141 is a positive input port, the second input port 10142 is connected to the negative input end Vin- of the power conversion circuit 102, and the second input port 10142 is a negative input port.

The third accommodation cavity 1013 has an output terminal 1015. The output terminal 1015 includes a first output terminal 10151 and a second output terminal 10152. When the first output terminal 10151 is connected to the positive output end Vout+ of the power conversion circuit 102, and the first output terminal 10151 is a positive output terminal, the second output terminal 10152 is connected to the negative output end Vout- of the power conversion circuit 102, and the second output terminal 10152 is a negative output terminal.

In this case, in the power converter, a current is input from the input port 1014, sequentially passes through the first electromagnetic compatibility module 1021 in the first accommodation cavity 1011, the bus capacitor 1023 in the second accommodation cavity 1012, and the second electromagnetic compatibility module 1022 in the third accommodation cavity 1013, and then is output from the output terminal 1015.

Optionally, in some feasible implementations, both the input end and the output end may be ports, or both the input end and the output end may be terminals, or the input end is a terminal, and the output end is a port. In other words, the input port 1014 and the output terminal 1015 in FIG. 1 may be understood as an example rather than a limitation, and the port or the terminal may be set based on specific product application.

In this embodiment of this application, currents flow in one direction, for example, in a clockwise direction, so that crosstalk between the currents can be reduced. This improves effect of EMC of the power converter.

In addition, the bus capacitor is generally an electrolytic capacitor with a large capacitance, and the electrolytic capacitor is heavy. When the first accommodation cavity and the third accommodation cavity are located on the two sides of the second accommodation cavity, the electrolytic capacitor that is heavy may be located in a middle part of the housing. The first electromagnetic compatibility module and the second electromagnetic compatibility module whose weights are roughly the same are disposed on the two sides, so that gravity of each part of the housing is balanced. This is convenient for transporting. In particular, in a scenario in which the power converter is used to be suspended, the gravity of each part of the housing is balanced. This facilitates suspending in all directions. In addition, a volume of the electrolytic capacitor is large. The electrolytic capacitor is placed in the second accommodation cavity in the middle. This facilitates a compact arrangement of other devices of the power converter and improves space utilization efficiency.

In addition, depths of the first accommodation cavity, the second accommodation cavity, and the third accommodation cavity may be set based on heights of devices accommodated by the first accommodation cavity, the second accommodation cavity, and the third accommodation cavity, so that power density of the power converter can be improved.

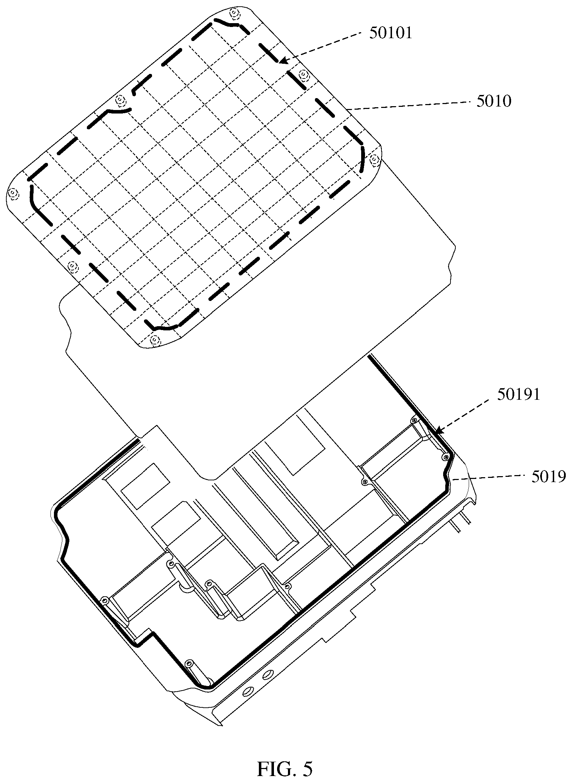

Refer to FIG. 5. In some feasible implementations, according to the power converter shown in FIG. 4, the housing sidewall and the cover plate shown in FIG. 5 are provided with conductive connecting pieces. In a specific implementation, a surface that is of the housing sidewall 5019 and that faces the cover plate 5010 is provided with a first conductive connecting piece 50191. A surface that is of the cover plate 5010 and that faces the housing sidewall 5019 is correspondingly provided with a second conductive connecting piece 50101. The first conductive connecting piece 50191 is attached to the second conductive connecting piece 50101. The first conductive connecting piece 50191 and the second conductive connecting piece 50101 may be made of a conductive material. In a case in which the first conductive connecting piece 50191 is attached to the second conductive connecting piece 50101, the housing sidewall 5019 and the cover plate 5010 may form a closed conductive cavity, to avoid an external leakage of electromagnetic interference generated by the power converter. This further improves effect of the EMC of the power converter.

It should be understood that the conductive connecting piece described in this application is a design for implementing an electrical connection between the housing and the printed circuit board. The conductive connecting piece may be a specially designed conductive structure. The structure is independent of the housing and the printed circuit board, or may be a partial structure of the housing or the printed circuit board. For example, when the conductive connecting piece is located on the printed circuit board, the conductive connecting piece may be a conductive coating used by the printed circuit board to be electrically connected to the housing. The conductive coating includes a copper coating, a nickel coating, and the like. When the conductive connecting piece is located on the housing, the conductive connecting piece is a part of a cavity sidewall forming the accommodation cavity that is in contact with the conductive coating.

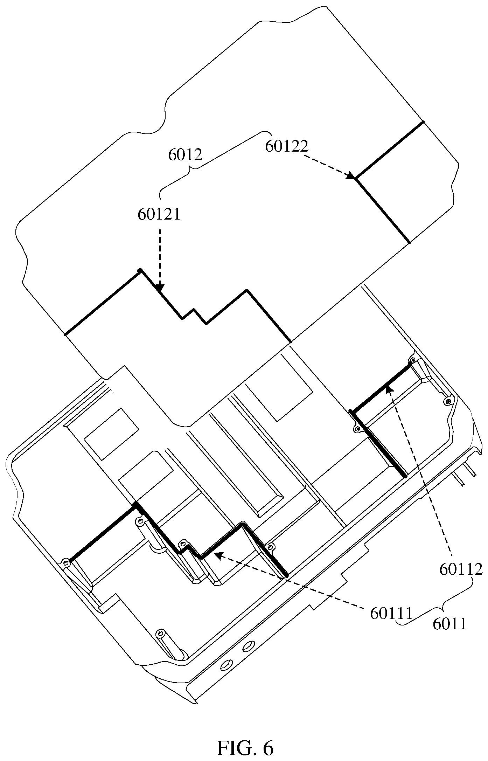

Refer to FIG. 6. In some feasible implementations, a surface that is of the cavity sidewall of any one of the plurality of accommodation cavities separated from each other and that faces the printed circuit board is provided with a third conductive connecting piece 6011. A surface that is of the printed circuit board and that faces the cavity sidewall is correspondingly provided with a fourth conductive connecting piece 6012. The third conductive connecting piece 6011 is attached to the fourth conductive connecting piece 6012.

For example, a surface that is of a cavity sidewall of the first accommodation cavity and that faces the printed circuit board is provided with a third conductive connecting piece 60111. A surface that is of the printed circuit board and that faces the cavity sidewall is correspondingly provided with a fourth conductive connecting piece 60121. The third conductive connecting piece 60111 is attached to the fourth conductive connecting piece 60121. In a specific implementation, the third conductive connecting piece 60111 may be made of a conductive material. The fourth conductive connecting piece 60121 may also be made of a conductive material, or may be specifically implemented as a conductive wire etched on the surface that is of the printed circuit board and that faces the cavity sidewall. In some feasible implementations, the fourth conductive connecting piece 60121 shown in FIG. 6 is an example. The surface that is of the printed circuit board and that faces the cavity sidewall needs to be correspondingly provided with the first electromagnetic compatibility module. Therefore, in a specific implementation, the fourth conductive connecting piece may be a part of the fourth conductive connecting piece 60121 shown in FIG. 6.

Similarly, a surface that is of a cavity sidewall of the third accommodation cavity and that faces the printed circuit board is provided with a third conductive connecting piece 60112. A surface that is of the printed circuit board and that faces the cavity sidewall is correspondingly provided with a fourth conductive connecting piece 60122. The third conductive connecting piece 60112 is attached to the fourth conductive connecting piece 60122. In a specific implementation, the third conductive connecting piece 60112 may also be made of a conductive material. The fourth conductive connecting piece may be made of a conductive material, or may be specifically implemented as a conductive wire etched on the surface that is of the printed circuit board and that faces the cavity sidewall. In some feasible implementations, the fourth conductive connecting piece 60122 shown in FIG. 6 is an example. The surface that is of the printed circuit board and that faces the cavity sidewall needs to be correspondingly provided with the second electromagnetic compatibility module. Therefore, in a specific implementation, the fourth conductive connecting piece may be a part of the fourth conductive connecting piece 60122 shown in FIG. 6.

In this embodiment of this application, the third conductive connecting piece is attached to the fourth conductive connecting piece. The cavity sidewall of any one of the cavities and the printed circuit board may form a closed or semi-closed conductive cavity, to reduce electromagnetic interference between accommodation cavities and avoid superposition of the electromagnetic interference. This may improve effect of the EMC of the power converter.

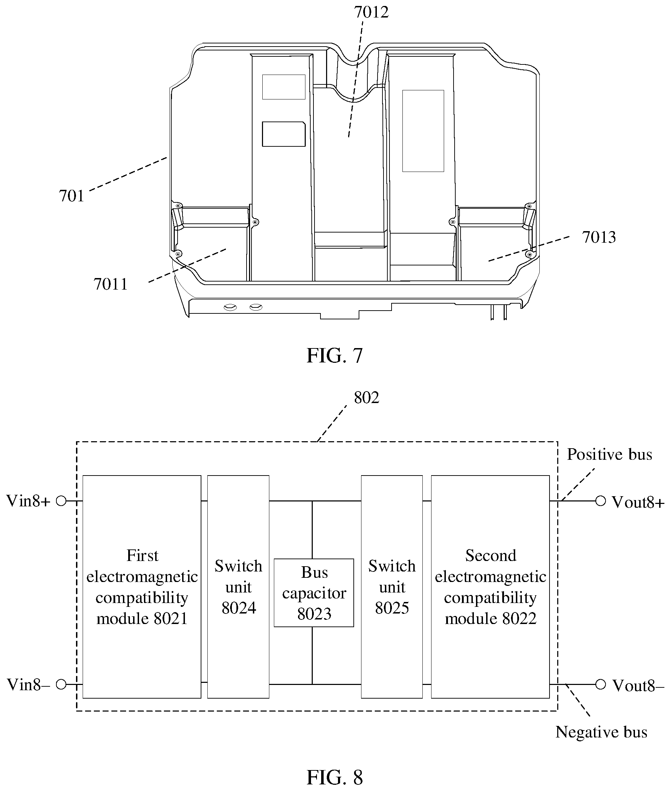

Refer to FIG. 7. In some feasible implementations, an embodiment of this application provides a power converter. Different from the power converter described above with reference to FIG. 1 to FIG. 6, in this embodiment of this application, an internal structure of a housing 701 is different from an internal structure of the housing 101. As shown in FIG. 7, a first accommodation cavity 7011, a second accommodation cavity 7012, and a third accommodation cavity 7013 are disposed in the housing 701. The first accommodation cavity 7011 and the third accommodation cavity 7013 are symmetrically distributed with respect to the second accommodation cavity 7012. Implementation of this embodiment of this application helps further improve effect of EMC of the power converter, and further improve power density of the power converter.

Refer to FIG. 1 and FIG. 8. In some feasible implementations, in addition to a first electromagnetic compatibility module 8021, a second electromagnetic compatibility module 8022, and a bus capacitor 8023, a power conversion circuit 802 further includes a switch unit 8024 and a switch unit 8025. In this case, the switch unit 8024 may be disposed in a sixth accommodation cavity 1016, and the switch unit 8025 is disposed in a seventh accommodation cavity 1017. The sixth accommodation cavity 1016 and the seventh accommodation cavity 1017 are located on the two sides of the second accommodation cavity 1012. The sixth accommodation cavity 1016 and the first accommodation cavity 1011 are located on a same side of the second accommodation cavity 1012. The seventh accommodation cavity 1017 and the third accommodation cavity 1013 are located on a same side of the second accommodation cavity 1012.

In this embodiment of this application, the switch unit in the power conversion circuit is divided into two parts, and the two parts are respectively disposed on the two sides of the second accommodation cavity, to avoid a squeeze between switching transistors in the switch unit. This facilitates heat dissipation of the switch unit, and may improve security and reliability of the power converter.

In addition, the first electromagnetic compatibility module 8021, the second electromagnetic compatibility module 8022, the bus capacitor 8023, the switch unit 8024, and the switch unit 8025 are located on a same side of the printed circuit board. Therefore, in a production process, the first electromagnetic compatibility module, the bus capacitor, the second electromagnetic compatibility module, and two switch units may be first welded on one side of the printed circuit board. The side that is of the printed circuit board and that is welded with the modules faces the bottom plate. In this case, the printed circuit board is covered at an opening of the housing, and the cover plate is further covered on a surface that is of the printed circuit board and that is away from the bottom plate, so that installation of the power converter can be completed.

A difference between the power converter and an existing power converter is that the switch unit, the first electromagnetic compatibility module, the bus capacitor, and the second electromagnetic compatibility module are separately located on two sides of the printed circuit board. In a production process, the first electromagnetic compatibility module, the bus capacitor, and the second electromagnetic compatibility module are first welded on a board body of the printed circuit board. The surface that is of the printed circuit board and that is provided with the first electromagnetic compatibility module, the bus capacitor, and the second electromagnetic compatibility module is covered at the opening of the housing. After being fixed, the welding process is returned. The switch unit is welded on a surface that is of the printed circuit board and that is away from the bottom plate. A production process is complex. Therefore, implementing this embodiment of this application can reduce an installation process, simplify a production process, and improve production efficiency.

Optionally, a first heat sink 10161 is disposed in a cavity of the sixth accommodation cavity 1016. The first heat sink 10161 may dissipate heat for the switch unit 6024. Further, the switch unit 8024 may be closely attached to the first heat sink 10161 by using a screw.

A second heat sink 10171 may also be disposed in a cavity of the seventh accommodation cavity 1017. The second heat sink 10171 may dissipate heat for the switch unit 6025. Similarly, the switch unit 8025 may also be closely attached to the second heat sink 10171 by using a screw.

The first heat sink 10161 and the second heat sink 10171 may include one or more heat dissipation modules. A specific implementation of the heat sink is not limited in this embodiment of this application.

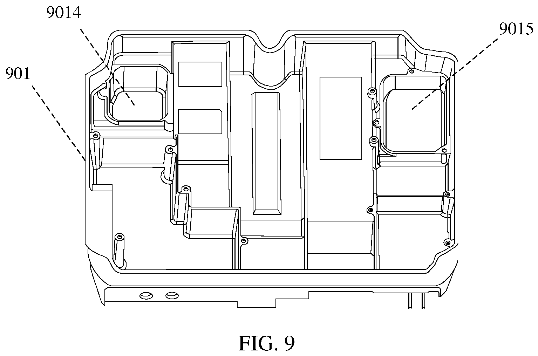

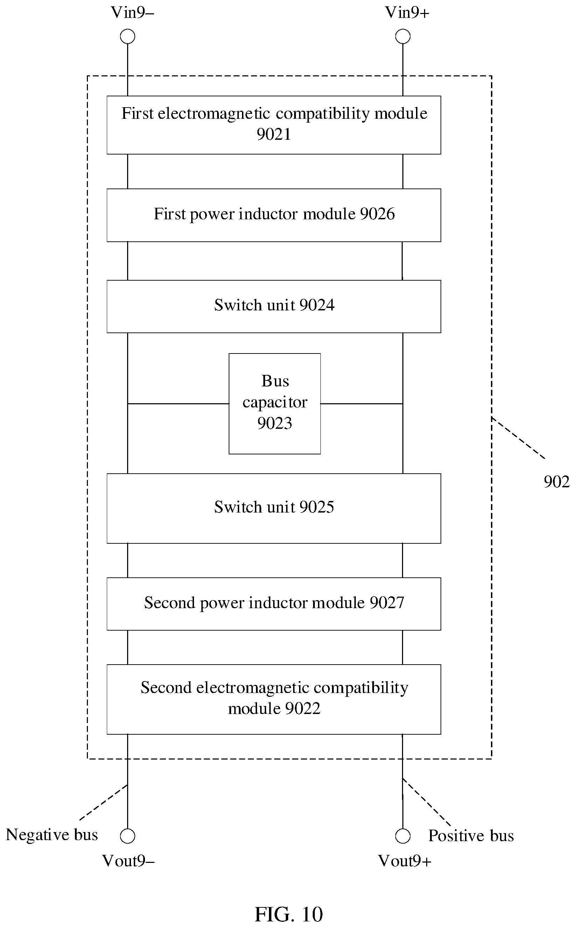

Refer to FIG. 9 and FIG. 10. In some feasible implementations, in addition to a first electromagnetic compatibility module 9021, a second electromagnetic compatibility module 9022, a bus capacitor 9023, a switch unit 9024, and a switch unit 9025, a power conversion circuit 902 further includes a first power inductor module 9026. The first power inductor module 9026 may be configured to perform filtering.

A housing 901 further includes a fourth accommodation cavity 9014. The fourth accommodation cavity 9014 and the first accommodation cavity are located on a same side of the second accommodation cavity. The fourth accommodation cavity 9014 may accommodate the first power inductor module 9026.

In this embodiment of this application, the first power inductor module is added to the power converter, so that interference from an input side of the power converter may be filtered out. In addition, the first power inductor module is disposed on a same side of the first accommodation cavity accommodating the first electromagnetic compatibility module, and currents still flow in one direction, for example, in a clockwise direction, so that effect of the EMC of the power converter may be further improved.

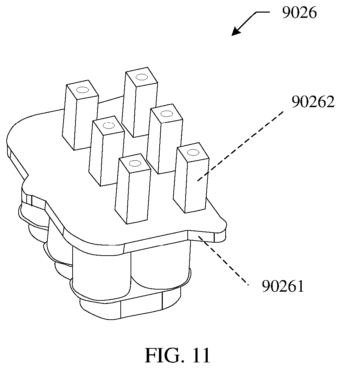

Optionally, refer to FIG. 11. In some feasible implementations, a side that is of the first power inductor module 9026 and that faces the printed circuit board is provided with a shielding board 90261. In this case, the first power inductor module 9026 establishes, by using a screw 90262, an electrical connection to the first electromagnetic compatibility module 9021 and the bus capacitor 9023 that are on the printed circuit board.

Optionally, in some feasible implementations, the power converter further includes a second power inductor module 9027. The second power inductor module 9027 may be configured to perform filtering.

The housing 901 further includes a fifth accommodation cavity 9015. The fifth accommodation cavity 9015 and the third accommodation cavity are located on a same side of the second accommodation cavity. The fifth accommodation cavity 9015 may accommodate the second power inductor module 9027.

In this embodiment of this application, the second power inductor module is added to the power converter, so that interference from an output side of the power converter may be filtered out. In addition, the second power inductor module is disposed on a same side of the third accommodation cavity accommodating the second electromagnetic compatibility module, and the currents still flow in one direction, for example, in a clockwise direction, so that effect of the EMC of the power converter may be further improved.

Optionally, in some feasible implementations, a specific implementation of the second power inductor module 9027 may be the same as that of the first power inductor module 9026. For example, a side that faces the printed circuit board is provided with a shielding board. In this case, the second power inductor module establishes, by using a screw, an electrical connection to the second electromagnetic compatibility module 9022 and the bus capacitor 9023 that are on the printed circuit board.

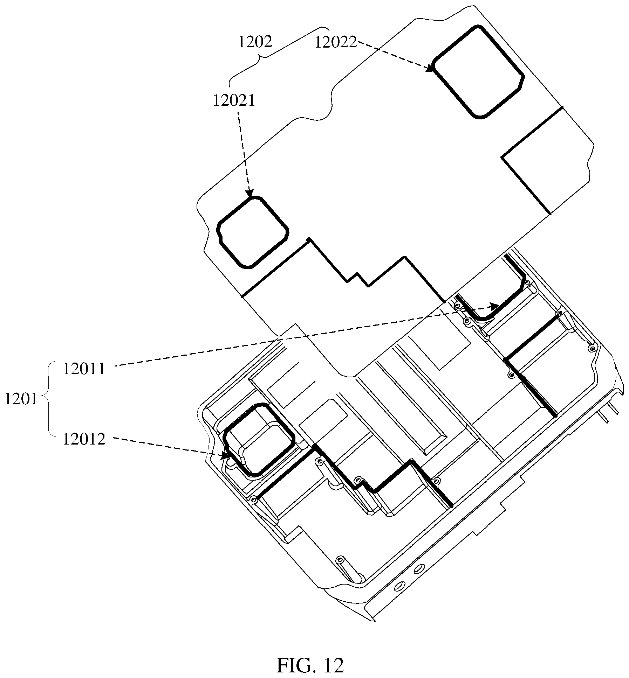

In some feasible implementations, when the power converter described above with reference to FIG. 1 to FIG. 12 is specifically used as an inverter, the inverter may be used in a scenario in which a direct current is converted into an alternating current, for example, a photovoltaic scenario or a wind power scenario. In this case, the power conversion circuit specifically includes a first DC/AC module. An input end of the first DC/AC module is connected to the first electromagnetic compatibility module or the first power inductor module. An output end of the first DC/AC module is connected to the second power inductor module or the second electromagnetic compatibility module. The first DC/AC module may convert a first direct current output by the first electromagnetic compatibility module or the first power inductor module into a first alternating current, and transmit the first alternating current to the second electromagnetic compatibility module.

For example, the first DC/AC module includes a first switch unit and a second switch unit. For example, the first switch unit may be an upper bridge arm in a three-phase bridge arm, and the second switch unit may be a lower bridge arm in the three-phase bridge arm. In this case, the first switch unit may be correspondingly disposed in the accommodation cavity of the switch unit 8024. In other words, the first switch unit is disposed in the sixth accommodation cavity. The second switch unit may be correspondingly disposed in the accommodation cavity of the switch unit 8025. In other words, the second switch unit is disposed in the seventh accommodation cavity.

Optionally, in some feasible implementations, when the power converter described above with reference to FIG. 1 to FIG. 12 may be specifically used as an uninterruptible power supply, the power conversion circuit further includes an AC/DC module and a second DC/AC module. An input end of the AC/DC module is connected to the first electromagnetic compatibility module or the first power inductor module. An output end of the AC/DC module is connected to the input end of the DC/AC module. The output end of the DC/AC module is connected to the second power inductor module or the second electromagnetic compatibility module. In this case, the AC/DC module is configured to: convert a second alternating current output by the first electromagnetic compatibility module into a second direct current, and transmit the second direct current to the second DC/AC module. The DC/AC module is configured to: convert the second direct current into a third alternating current, and transmit the third alternating current to the second electromagnetic compatibility module.

For example, the AC/DC module includes a third switch unit, and the second DC/AC module includes a fourth switch unit. In this case, the third switch unit may be correspondingly disposed in the accommodation cavity of the switch unit 8024. In other words, the third switch unit is disposed in the sixth accommodation cavity. The fourth switch unit may be correspondingly disposed in the accommodation cavity of the switch unit 8025. In other words, the fourth switch unit is disposed in the seventh accommodation cavity.

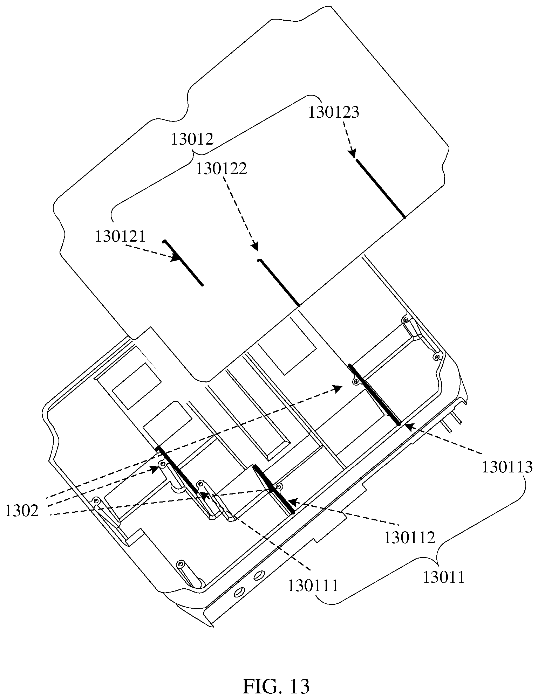

FIG. 13 is a block diagram of another three-dimensional structure of a power converter according to an embodiment of this application. The power converter includes an EMC conductive coating 13012 located on the printed board, a partial cavity sidewall 13011 that is located on the housing and that forms the accommodation cavity, and a threaded hole 1302 configured to fasten the printed circuit board and the housing. The EMC conductive coating 13012 is located on a side that is of the printed circuit board and that faces the housing. The EMC conductive coating 13012 includes a first coating 130121, a second coating 130122, and a third coating 130123. The partial cavity sidewall 13011 includes a first retaining wall 130111, a second retaining wall 130112, and a third retaining wall 130113. After installation is completed, the EMC conductive coating 13012 is in tight contact with the partial cavity sidewall 13011. In a direction perpendicular to the printed circuit board, a projection of the first coating 130121 overlaps a projection of the first retaining wall 130111, a projection of the second coating 130122 overlaps a projection of the second retaining wall 130112, and a projection of the third coating 130123 overlaps a projection of the third retaining wall 130113. The threaded hole 1302 is disposed close to the partial cavity sidewall 13011, to strengthen fastening between the partial cavity sidewall 13011 and the metal coating 13012, so that it is ensured that the two are always electrically connected. The conductive coating may be a copper coating, a nickel coating, or the like. The conductive coating and the cavity sidewall form a plurality of closed or semi-closed EMC isolation cavities.

It should be noted that, the terms "first" and "second" are merely intended for a purpose of description, and cannot be understood as indicating or implying relative importance.

In addition, in this specification, position terms such as "top" and "bottom" are defined relative to positions of structures in the accompanying drawings. It should be understood that these position terms are relative concepts used for relative description and clarification, and may correspondingly change according to changes in the positions of the structures.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A power converter, wherein the power converter comprises a housing and a power conversion circuit, a plurality of accommodation cavities separated from each other are disposed in the housing, and the plurality of accommodation cavities separated from each other comprise a first accommodation cavity, a second accommodation cavity, and a third accommodation cavity;
the power conversion circuit comprises a first electromagnetic compatibility module, a bus capacitor, and a second electromagnetic compatibility module; and
the first accommodation cavity is configured to accommodate the first electromagnetic compatibility module, the second accommodation cavity is configured to accommodate the bus capacitor, the third accommodation cavity is configured to accommodate the second electromagnetic compatibility module, and the first accommodation cavity and the third accommodation cavity are located on two sides of the second accommodation cavity.

2. The power converter according to claim 1, wherein the first accommodation cavity and the third accommodation cavity are symmetrically distributed with respect to the second accommodation cavity.

3. The power converter according to either of claims 1 and 2, wherein the plurality of accommodation cavities separated from each other further comprise a fourth accommodation cavity, and the power conversion circuit further comprises a first power inductor module; and
the fourth accommodation cavity is configured to accommodate the first power inductor module, and the fourth accommodation cavity and the first accommodation cavity are located on a same side of the second accommodation cavity.

4. The power converter according to claim 3, wherein the power converter further comprises a printed circuit board located in the housing, and the printed circuit board is configured to carry the first electromagnetic compatibility module and the bus capacitor; and
a side that is of the first power inductor module and that faces the printed circuit board is provided with a shielding board, and the first power inductor module establishes, by using a screw, an electrical connection to the first electromagnetic compatibility module and the bus capacitor that are on the printed circuit board.

5. The power converter according to any one of claims 1 to 4, wherein the plurality of accommodation cavities separated from each other further comprise a fifth accommodation cavity, and the power conversion circuit further comprises a second power inductor module; and
the fifth accommodation cavity is configured to accommodate the second power inductor module, and the fifth accommodation cavity and the third accommodation cavity are located on a same side of the second accommodation cavity.

6. The power converter according to claim 5, wherein the power converter further comprises the printed circuit board located in the housing, and the printed circuit board is configured to carry the bus capacitor and the second electromagnetic compatibility module; and
a side that is of the second power inductor module and that faces the printed circuit board is provided with a shielding board, and the second power inductor module establishes, by using a screw, an electrical connection to the bus capacitor and the second electromagnetic compatibility module that are on the printed circuit board.

7. The power converter according to any one of claims 1 to 6, wherein the housing comprises a bottom plate, a housing sidewall, and a cover plate, and the bottom plate, the housing sidewall, and the cover plate define the plurality of accommodation cavities separated from each other.

8. The power converter according to claim 7, wherein a surface that is of the housing sidewall and that faces the cover plate is provided with a first conductive connecting piece, and a surface that is of the cover plate and that faces the housing sidewall is correspondingly provided with a second conductive connecting piece; and
the first conductive connecting piece is attached to the second conductive connecting piece.

9. The power converter according to any one of claims 1 to 8, wherein the power converter further comprises the printed circuit board located in the housing, and the printed circuit board is configured to carry the first electromagnetic compatibility module, the bus capacitor, and the second electromagnetic compatibility module; and
the first electromagnetic compatibility module, the bus capacitor, and the second electromagnetic compatibility module are located on a surface that is of the printed circuit board and that faces the bottom plate of the housing.

10. The power converter according to claim 9, wherein a surface that is of a cavity sidewall of any one of the plurality of accommodation cavities separated from each other and that faces the printed circuit board is provided with a third conductive connecting piece, and a surface that is of the printed circuit board and that faces the cavity sidewall is correspondingly provided with a fourth conductive connecting piece; and
the third conductive connecting piece is attached to the fourth conductive connecting piece.

11. The power converter according to any one of claims 1 to 10, wherein the first accommodation cavity has an input port, and the input port is configured to establish a connection between the first electromagnetic compatibility module and a direct current power supply;
the third accommodation cavity has an output terminal, and the output terminal is configured to establish a connection between the second electromagnetic compatibility module and an alternating current load; and
the power conversion circuit further comprises a first DC/AC module, and the DC/AC module is configured to: convert a first direct current output by the first electromagnetic compatibility module into a first alternating current, and transmit the first alternating current to the second electromagnetic compatibility module.

12. The power converter according to claim 11, wherein the first electromagnetic compatibility module comprises at least one first inductor and at least one first capacitor, the first inductor and the first capacitor are configured to form a first low-pass filter circuit, and the first low-pass filter circuit is configured to filter out high-frequency interference caused by the direct current power supply; and
the second electromagnetic compatibility module comprises at least one second inductor and at least one second capacitor, the second inductor and the second capacitor are configured to form a second low-pass filter circuit, and the second low-pass filter circuit is configured to filter out high-frequency interference generated by the power converter.

13. The power converter according to either of claims 11 and 12, wherein the first DC/AC module comprises a first switch unit and a second switch unit; and
the plurality of accommodation cavities separated from each other comprise a sixth accommodation cavity and a seventh accommodation cavity, the sixth accommodation cavity is configured to accommodate the first switch unit, the seventh accommodation cavity is configured to accommodate the second switch unit, and the sixth accommodation cavity and the seventh accommodation cavity are located on the two sides of the second accommodation cavity.

14. The power converter according to claim 13, wherein the power converter further comprises a first heat sink and a second heat sink;
the first heat sink is located in the sixth accommodation cavity and is configured to dissipate heat for the first switch unit, and the second heat sink is located in the seventh accommodation cavity and is configured to dissipate heat for the second switch unit;
the power converter further comprises the printed circuit board located in the housing, and the printed circuit board is configured to carry the first switch unit and the second switch unit; and
the first switch unit and the second switch unit are located on the surface that is of the printed circuit board and that faces the bottom plate of the housing.

15. The power converter according to any one of claims 1 to 10, wherein the first accommodation cavity has an input port, and the input port is configured to establish a connection between the first electromagnetic compatibility module and an alternating current power supply;
the third accommodation cavity has an output terminal, and the output terminal is configured to establish a connection between the second electromagnetic compatibility module and an alternating current load;
the power conversion circuit further comprises an AC/DC module and a second DC/AC module, and the AC/DC module is configured to: convert a second alternating current output by the first electromagnetic compatibility module into a second direct current, and transmit the second direct current to the second DC/AC module; and
the second DC/AC module is configured to: convert the second direct current into a third alternating current, and transmit the third alternating current to the second electromagnetic compatibility module.

16. The power converter according to claim 15, wherein the first electromagnetic compatibility module comprises at least one third inductor and at least one third capacitor, the third inductor and the third capacitor are configured to form a third low-pass filter circuit, and the third low-pass filter circuit is configured to filter out high-frequency interference caused by the alternating current power supply; and
the second electromagnetic compatibility module comprises at least one fourth inductor and at least one fourth capacitor, the fourth inductor and the fourth capacitor are configured to form a fourth low-pass filter circuit, and the fourth low-pass filter circuit is configured to filter out high-frequency interference generated by the power converter.

17. The power converter according to claim 15, wherein the AC/DC module comprises a third switch unit, and the second DC/AC module comprises a fourth switch unit; and
the plurality of accommodation cavities separated from each other comprise a sixth accommodation cavity and a seventh accommodation cavity, the sixth accommodation cavity is configured to accommodate the third switch unit, the seventh accommodation cavity is configured to accommodate the fourth switch unit, and the sixth accommodation cavity and the seventh accommodation cavity are located on the two sides of the second accommodation cavity.

18. The power converter according to claim 17, wherein the power converter further comprises a first heat sink and a second heat sink;
the first heat sink is located in the sixth accommodation cavity and is configured to dissipate heat for the third switch unit, and the second heat sink is located in the seventh accommodation cavity and is configured to dissipate heat for the fourth switch unit;
the power converter further comprises the printed circuit board located in the housing, and the printed circuit board is configured to carry the third switch unit and the fourth switch unit; and
the third switch unit and the fourth switch unit are located on the surface that is of the printed circuit board and that faces the bottom plate of the housing.

19. The power converter according to claim 9, wherein the printed circuit board comprises an EMC conductive coating, the EMC conductive coating on the printed circuit board is closely attached to a cavity sidewall of any one of the plurality of accommodation cavities separated from each other, and in a direction perpendicular to the printed circuit board, a projection of the EMC conductive coating on the printed circuit board overlaps a projection of the cavity sidewall of any one of the plurality of accommodation cavities separated from each other.

20. The power converter according to claim 10, wherein the housing beside the cavity sidewall of any one of the plurality of accommodation cavities separated from each other is provided with a threaded hole, the printed circuit board is provided with a threaded through hole, in a direction perpendicular to the printed circuit board, a projection of the threaded hole overlaps a projection of the threaded through hole, and the threaded hole and the threaded through hole are configured to fasten a connection between the cavity sidewall of any one of the plurality of accommodation cavities separated from each other and an EMC conductive coating on the printed circuit board.
